# EUROPÄISCHE PATENTSCHRIFT

(11) **EP 0 826 232 B1**
(45) Veröffentlichungstag und Bekanntmachung des Hinweises auf die Patenterteilung: **03.11.1999**
(21) Anmeldenummer: 96914162.1
(22) Anmeldetag: 02.05.1996
(51) Int. Cl.: H01L 21/00

(54) **VERFAHREN UND VORRICHTUNG ZUR NASSBEHANDLUNG VON SUBSTRATEN IN EINEM BEHÄLTER**
METHOD AND DEVICE FOR WET-PROCESSING SUBSTRATES IN A VESSEL
PROCEDE ET DISPOSITIF POUR LE TRAITEMENT PAR VOIE HUMIDE DE SUBSTRATS DANS UN RECIPIENT

(30) Priorität: 12.05.1995 DE 19517573
(43) Veröffentlichungstag der Anmeldung: 04.03.1998
(73) Patentinhaber: STEAG MicroTech GmbH, 72124 Pliezhausen (DE)
(72) Erfinder: DENZLER, Ludwig, D-75210 Keltern (DE); HARMS-JANSSEN, Helmuth, D-75038 Oberderdingen (DE)
(86) Internationale Anmeldenummer: EP9601813
(87) Internationale Veröffentlichungsnummer: WO9636068

(56) Entgegenhaltungen:
- EP-A- 0 385 536
- EP-A- 0 455 465
- AT-A- 208 307
- US-A- 4 722 752

## Beschreibung

Die Erfindung betrifft ein Verfahren zur Naßbehandlung von Substraten in einem Behälter, in dem wenigstens eine Flüssigkeit, nachfolgend auch als Fluid bezeichnet, eingeleitet und über eine Überlaufvorrichtung abgeführt wird. Die Erfindung betrifft weiterhin eine Vorrichtung zur Naßbehandlung von Substraten in einem Behälter, der wenigstens einen Fluideinlaß und eine Fluid-Überlaufeinrichtung mit Öffnungen zum Abführen eines Fluid aufweist.

Verfahren und Vorrichtungen der genannten Art sind beispielsweise aus der US-A-4 722 752 und der EP-A-0 385 536 bekannt, sowie in den auf dieselbe Anmelderin zurückgehenden, nicht vorveröffentlichten DE-A-44 13 077 und DE-A-195 46 990 beschrieben. Auf der Oberseite des das Fluid und die Substrate enthaltenden Behälters sind Überlaufeinrichtungen vorgesehen, wobei das Fluid von unten eingeleitet wird, an den Substraten vorbei nach oben und durch Überlauföffnungen oder -kanten an der Oberseite des Behälters aus ihm ausströmt. Nach der Naßbehandlung, beispielsweise nach einem Spülvorgang, werden die Substrate mit einer mehr oder weniger komplizierten Mechanik entweder zusammen mit einem Substratträger oder direkt aus dem Fluid bzw. dem Behälter herausgehoben, wobei der Überlaufabfluß dafür sorgt, daß Partikel und sonstige Verunreinigungen auf der Fluid-Oberfläche nach außen in die Überlaufeinrichtung durch die Strömung mitgeführt werden und während des Heraushebens der Substrate aus dem Fluid im wesentlichen nicht an den Substraten haften bleiben.

Die mechanischen Einrichtungen zum sicheren und gleichmäßigen Herausheben der Substrate aus dem Fluid bzw. aus dem Behälter sind sehr aufwendig und kompliziert.

Darüberhinaus beanspruchen die Hebemechanismen im Behälter selbst relativ viel Platz, da sie unter den Substratträger bzw. unter die Substrate greifen und diese anheben müssen. Abgesehen davon, daß die Behälterabmessungen relativ groß sein müssen, ist damit auch ein relativ großer Fluidverbrauch verbunden, wenn das Fluid ausgetauscht oder ersetzt werden muß.

Ein besonderer Nachteil bei dem Herausführen der Wafer aus dem Behälter besteht auch darin, daß sehr genau gearbeitete Führungen für die Wafer an den Hebemechanismen, und in der über dem Behälter angeordneten Haube für die Wafer ausgebildet sein müssen, um die Wafer sicher und zuverlässig während des Aushebens aus dem Behälter in einer definerten Lage zu halten. Die Fertigungskosten für derartige Führungen sind auf Grund der erforderlichen sehr genauen Bearbeitung hoch, wobei zusätzlich bei den herkömmlichen Vorrichtungen eine Beschädigung oder ein Bruch der Substrate beim Herausfahren aus dem Behälter nur durch zusätzlichen hohen Justageaufwand zu vermeiden ist.

Aus der AT 208 307 ist eine Zumeßvorrichtung zur proportionalen Einbringung von Chemikalienlösungen in periodisch beschickte Behälter bekannt. Die Zumeßvorrichtung umfaßt einen nach außen hermetisch abgeschlossenen Chemikalienbehälter, der über einem Flüssigkeitsbehälter angeordnet ist. Im Flüssigkeitsbehälter ist eine Luftverdrängungsglocke vorgesehen, die zum Flüssigkeitsbehälter hin nach unten offen ist und an der höchsten Stelle über ein Verbindungsrohr mit dem hermetisch abgeschlossenen Chemikalienbehälter 1 kommuniziert. Im Innern des abgeschlossenen Chemikalienbehälters befindet sich ein Schwimmer mit einem Rohr, dessen freie Öffnung mit dem unteren Rand des Schwimmers abschneidet. Bei ganz- oder teilweiser Füllung des Flüssigkeitsbehälters wird eine entsprechende Menge Luft in den hermetisch abgeschlossenen Chemikalienbehälter gedrängt, so daß in diesem abgeschlossenen Behälter ein Überdruck entsteht, der die Chemikalienlösung durch die Öffnung am unteren Abschluß des Schwimmers drückt, so daß eine entsprechende Menge Chemikalienlösung über einen Schlauch zur dosierten Einführung der Chemikalie in den Flüssigkeitsbehälter strömt. Eine derartige Zumeßvorrichtung ermöglicht die Zumessung einer Flüssigkeit proportional zu einer in einem Flüssigkeitsbehälter nachzufüllenden Flüssigkeitsmenge durch Luftverdrängung, so daß diese bekannte Vorrichtung einem grundsätzlich anderen Zwecke dient, ganz abgesehen davon, daß der Behälter zu diesem Zwecke hermetisch abgeschlossen sein muß, um einen Überdruck zu erzeugen.

Aus der EP-A-0 455 465 ist eine Wasch- oder Spülvorrichtung mit einem Überlaufbecken bekannt, bei dem das Wasch- oder Spülfluid von unten eingeleitet wird und am oberen Rand aus dem Becken überfließt. In dem Bereich, in den die Flüssigkeit nach dem Überlauf einströmt, befindet sich eine Schaum-Unterdrückungsvorrichtung in Form eines schwimmenden Ventils, das sich in Abhängigkeit des Flüssigkeitsstands in der Überlaufrinne hebt und senkt, so daß dadurch der nach unten gerichtete Abfluß der Spülflüssigkeit geregelt wird.

Der Erfindung liegt die Aufgabe zugrunde, ein Verfahren und eine Vorrichtung der eingangs genannten Art anzugeben bzw. zu schaffen, das bzw. die sowohl hinsichtlich der Verfahrensweise als auch hinsichtlich des konstruktiven Aufwands wesentlich einfacher ist und dennoch eine sichere und zuverlässige Handhabung der Substrate gewährleistet.

Die gestellte Aufgabe wird erfindungsgemäß durch die Merkmale des Anspruchs 1 gelöst.

Im Gegensatz zu den herkömmlichen Verfahren werden die Substrate nicht aus dem Fluid herausgehoben, sondern das Fluid wird ohne Lageänderung der Substrate im Behälter abgesenkt. Da die Überlaufeinrichtung gemäß der vorliegenden Erfindung auf dem Fluid schwimmt, und sich zusammen mit der Fluid-Oberfläche absenkt, werden die auf der Fluid-Oberfläche schwimmenden Partikel und Verunreinigungen auch bei Absenken der Fluid-Oberfläche durch die Strömung zur Überlaufeinrichtung hin mitgerissen und setzen sich nicht an den Substraten ab. Ohne die erfindungsgemäße, auf dem Fluid schwimmende Überlaufeinrichtung blieben bei Absenken der Fluid-Oberfläche die Partikel und Verunreinigungen an den Substratoberflächen haften und würden die Substrate nach dem eigentlichen Behandlungs- oder Spülvorgang wieder kontaminieren.

Das erfindungsgemäße Verfahren bzw. die erfindungsgemäße Vorrichtung benötigt keine Hebeeinrichtungen wie bei den herkömmlichen Verfahren, so daß die für das Verfahren erforderlichen Einrichtungen wesentlich einfacher und kostengünstiger zu fertigen sind. Darüber hinaus sind die Abmessungen des Behälters klein, so daß das erforderliche Fluidvolumen ebenfalls gering gehalten werden kann, was zu erheblichen Einsparungen beim Betreiben derartiger Naßbehandlungsanlagen führt. Da die Substrate nicht aus dem Behälter herausgeführt werden müssen, sind auch keine Führungen oberhalb des Behälters, beispielsweise in Hauben, erforderlich, wodurch das erfindungsgemäße Verfahren mit sehr einfachen Vorrichtungen durchführbar ist. Auch sind Hauben hierfür nur dafür erforderlich, um die Prozeßkammer abzudecken und ein Gasgemisch zuzuführen. Die Behandlung, z. B. die Trocknung der Substrate im Behälter selbst ist daher wesentlich sicherer und die Gefahr von Beschädigungen der Substrate ist nicht gegeben.

Gemäß einer vorteilhaften Ausführungsform der Erfindung fließt das Fluid über Überlauföffnungen der Überlaufeinrichtung sowie von dort über wenigstens eine mit ihr verbundene Leitung aus dem Behälter aus. Nach dem Ausfließen des Fluids aus dem Behälter verbleiben die Substrate im Behälter und können danach auf einfache Weise beispielsweise als Einheit zusammen mit einem Substratträger auf einfache Weise herausgehoben und weiter behandelt werden.

Die gestellte Aufgabe wird erfindungsgemäß auch mit einer Vorrichtung gelöst, bei der die Überlaufeinrichtung schwimmfähig und auf der Fluid-Oberfläche vorgesehen ist, wobei die Überlaufeinrichtung zur Freigabe bzw. Flutung der im Behälter befindlichen Substrate zusammen mit der Fluid-Oberfläche bis unter die Substrate absenk- bzw. von dort anhebbar ist. Die im Zusammenhang mit dem erfindungsgemäßen Verfahren bereits erläuterten Vorteile der Erfindung treffen auch für die erfindungsgemäße Vorrichtung zu.

Die Überlaufeinrichtung weist Fluidablaufleitungen auf, die zum Ableiten des Fluids mit wenigstens einer Behälteröffnung verbunden sind. Vorzugsweise ist die wenigstens eine Behälteröffnung am Boden des Behälters vorgesehen, so daß das Fluid ohne zusätzliche Verwendung einer Pumpe ausfließen kann.

Da sich die auf der Fluidoberfläche schwimmende Überlaufeinrichtung zusammen mit dem Fluid absenkt und/oder anhebt, muß die Fluid-Ablaufleitung dieser Bewegung folgen können. Vorzugsweise ist die Fluid-Ablaufleitung daher ein elastischer Schlauch, ein balgartiger Schlauch und/oder ein teleskopartig einfahrbares bzw. ausfahrbares Rohr. Gemäß einer alternativen Ausführungsform der Erfindung ist die Fluid-Ablaufleitung ein Rohr, das dichtend durch eine im wesentlichen auf dem Boden des Behälters ausgebildete Behälteröffnung ein- und ausschiebbar ist.

Die Überlaufeinrichtung sollte vorzugsweise die Substrate umgeben, so daß auch bei Absenken der Fluid-Oberfläche immer eine gleichmäßige Fluidströmung nach außen gewährleistet ist, die die Partikel und Verunreinigungen von den innerhalb der Überlaufeinrichtung angeordneten Substraten entfernt. Die Überlaufeinrichtung ist daher vorzugsweise ein die Substrate umgebender, schwimmfähiger Ring. Es ist jedoch auch möglich, die Überlaufeinrichtung in ihrer Umfangsform so zu gestalten, daß sie im wesentlichen der Querschnittsform des Behälterinnenraums entspricht. Ist der Behälterinnenraum beispielsweise rechteckförmig, so ist die Überlaufeinrichtung gemäß dieser Ausführungsform der Erfindung ein rechteckförmig gelegter Schlauch. Die Überlaufeinrichtung, sei sie nun ringförmig oder entsprechend der Querschnittsform des Behälterinnenraums ausgebildet, ist vorzugsweise während ihres Absenkens bzw. Anhebens im Behälter geführt, um dabei eine definierte Lage sicherzustellen.

Um eine möglichst gleichmäßige Strömung auf der Fluid-oberfläche von innen nach außen und von den Substraten weg nach außen sicherzustellen, ist es vorteilhaft, die Überlauföffnungen über den Umfang der Überlaufeinrichtung gleichmäßig verteilt auszubilden, beispielsweise in Form von Löchern oder Schlitzen in einem Ring oder einem Rohr.

Gemäß einer weiteren Ausbildung der erfindungsgemäßen Vorrichtung ist über dem Behälter eine abnehmbare Haube vorgesehen, die vorteilhafterweise eine Gaseinlaßvorrichtung aufweist, um für den Trocknungsvorgang Gas einführen zu können, wie dies im Zusammenhang mit der EP O 385 536 A beschrieben ist. Das über die Gaseinlaßvorrichtung eingeleitete Gas wird vorteilhafterweise über die Überlauföffnungen der Überlaufeinrichtung zusammen mit dem ausströmenden Behandlungsfluid abgeführt.

Die Erfindung wird nachstehend anhand eines Ausführungsbeispiels unter Bezugnahme auf eine einzige, schematische Querschnittszeichnung erläutert.

In einem Behälter 1, beispielsweise einem Fluidbehandlungs- oder Spülbecken, befindet sich eine auf dem Behälterboden stehende Aufnahmeeinrichtung 2 für Substrate 3, beispielsweise Wafer, die parallel nebeneinander angeordnet sind. Auf der Fluid-Oberfläche 4 schwimmt eine Überlaufeinrichtung 5, die beispielsweise ringförmig ausgebildet ist und die Substrate 3 umgibt, ohne daß beim Absenken des Fluids und damit der auf der Fluid-Oberfläche 4 schwimmenden Überlaufeinrichtung 5 diese mit den Substraten 3 in Berührung kommt. In der Überlaufeinrichtung 5 befinden sich Öffnungen 6, durch die das Fluid in ein Teleskoprohr 7 strömt, das an seinem unteren Ende mit einer Öffnung 8 im Behälter 1 verbunden ist. Das Fluid strömt dadurch aus dem Behälter 1 in ein mit einem Absperrorgan 9 schließbares Abflußrohr 10 aus und - sofern nicht entsprechend dasselbe Fluidvolumen über ein Einlaßrohr 11 in den Behälter eingeführt wird - senkt sich die Überlaufeinrichtung 5 zusammen mit dem Fluid ab, bis sie unterhalb der Substrate 3 ankommt. Während des Absenkens der Überlaufeinrichtung 5 schiebt sich das Teleskoprohr 7 zusammen und verkürzt sich dadurch.

Nach dem Absenken der Überlaufeinrichtung 5 unter die unterste Kante der Substrate 3 liegen diese frei und können entweder zusammen mit der Aufnahmeeinrichtung 2 oder einem auf der Aufnahmeeinrichtung 2 angeordneten Träger, oder aber einzeln aus dem Behälter 1 in der üblichen Weise von oben aus dem Behälter herausgehoben und weiterbehandelt werden.

Durch eine gleichmäßige Verteilung der Überlauföffnungen 6 in der Überlaufeinrichtung 5 ergibt sich eine konstante Strömung des Fluids von innen nach außen, d. h. von den Substraten 3 weg nach außen, so daß auch Partikel und Verunreinigungen, die auf der Fluid-Oberfläche 4 aufschwimmen, von den Substraten 3 weg mit in die Überlaufeinrichtung 5 gezogen werden. Die Substrate 3 bleiben daher auch bei Entfernen des Fluids aus dem Behälter 1 frei von Partikeln und Verunreinigungen.

Die Erfindung wurde zuvor anhand eines bevorzugten Ausführungsbeispiels erläutert. Dem Fachmann sind jedoch zahlreiche Abwandlungen und Ausgestaltungen möglich, ohne daß dadurch der Erfindungsgedanke verlassen wird. Beispielsweise kann die Überlaufeinrichtung 5 in verschiedenster Weise, beispielsweise in Form von Röhren, ausgebildet sein, in denen den vorliegenden Bedingungen entsprechend ausgebildete Öffnungen 6 etwa auch auf der Außenumfangsfläche ausgebildet sein können. Statt des Teleskoprohrs 7 ist es auch möglich, ein balgartiges Rohr zu verwenden, das sich bei Absenken der Überlaufeinrichtung 5 zusammenfaltet.

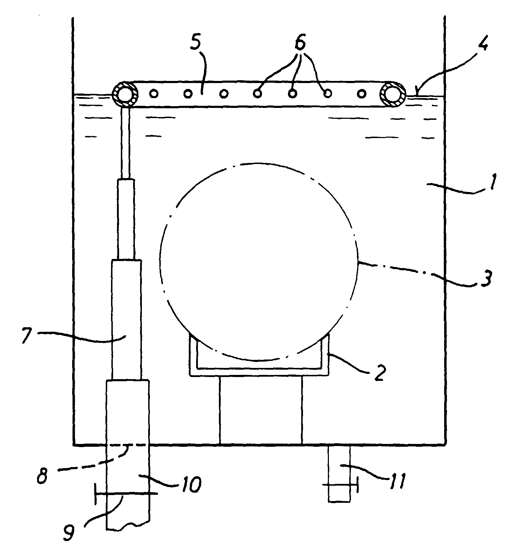

## Patentansprüche

1. Verfahren zur Naßbehandlung von Substraten in einem Behälter, in dem wenigstens eine Flüssigkeit eingeleitet und über eine Überlaufeinrichtung abgeführt wird, dadurch **gekennzeichnet**, daß die Überlaufeinrichtung auf der Flüssigkeit im Behälter schwimmt und sich bei Freigabe bzw. Flutung der im Behälter befindlichen Substrate zusammen mit der Flüssigkeits-Oberfläche bis unter die Substrate absenkt bzw. von dort anhebt.

2. Verfahren nach Anspruch 1, dadurch gekennzeichnet, daß die Flüssigkeit über Überlauföffnungen der Überlaufeinrichtung sowie über wenigstens eine mit ihr verbundene Leitung aus dem Behälter ausfließt.

3. Vorrichtung zur Naßbehandlung von Substraten (3) in einem Behälter (1), der wenigstens einen Flüssigkeitseinlaß (11) und eine Flüssigkeits-Überlaufeinrichtung (5) mit Öffnungen (6) zum Abführen einer Flüssigkeit aufweist, dadurch **gekennzeichnet**, daß die Überlaufeinrichtung (5) schwimmfähig, auf der Flüssigkeits-Oberfläche (4) im Behälter (1) vorgesehen und bei Freigabe bzw. Flutung der im Behälter (1) befindlichen Substrate (3) zusammen mit ihr bis unter die Substrate (3) absenk- bzw. von dort anhebbar ist.

4. Vorrichtung nach Anspruch 3, dadurch gekennzeichnet, daß die Überlaufeinrichtung (5) Flüssigkeits-Überlauföffnungen (6) aufweist.

5. Vorrichtung nach Anspruch 3 oder 4, dadurch gekennzeichnet, daß die Überlaufeinrichtung (5) Flüssigkeits-Ablaufeinrichtungen (7) aufweist.

6. Vorrichtung nach einem der Ansprüche 3 bis 5, dadurch gekennzeichnet, daß wenigstens eine Flüssigkeits-Ablaufleitung (7) zwischen der Überlaufeinrichtung (5) und wenigstens einer Behälteröffnung (8) vorgesehen ist.

7. Vorrichtung nach Anspruch 6, dadurch gekennzeichnet, daß die Behälteröffnung (8) am Boden des Behälters (1) vorgesehen ist.

8. Vorrichtung nach Anspruch 6 oder 7, dadurch gekennzeichnet, daß die Flüssigkeits-Ablaufleitung (7) ein elastischer Schlauch ist.

9. Vorrichtung nach Anspruch 6 oder 7, dadurch gekennzeichnet, daß die Flüssigkeits-Ablaufleitung (7) ein balgartiger Schlauch ist.

10. Vorrichtung nach Anspruch 6 oder 7, dadurch gekennzeichnet, daß die Flüssigkeits-Ablaufleitung (7) ein Teleskoprohr ist.

11. Vorrichtung nach Anspruch 6 oder 7, dadurch gekennzeichnet, daß die Flüssigkeits-Ablaufleitung (7) ein Rohr ist, das dichtend durch die Behälteröffnung (8) ein- und ausschiebbar ist.

12. Vorrichtung nach einem der Ansprüche 4 bis 11, dadurch gekennzeichnet, daß die Überlaufeinrichtung (5) ein die Substrate umgebender, schwimmfähiger Ring ist.

13. Vorrichtung nach einem der Ansprüche 4 bis 12, dadurch gekennzeichnet, daß die Umfangsform der Überlaufeinrichtung (5) der Querschnittsform des Behälterinnenraums entspricht.

14. Vorrichtung nach einem der Ansprüche 4 bis 13, dadurch gekennzeichnet, daß die Überlaufeinrichtung (5) während ihres Absenkens bzw. Anhebens im Behälter (1) geführt ist.

15. Vorrichtung nach einem der Ansprüche 4 bis 14, dadurch gekennzeichnet, daß die Überlauföffnungen (6) über den Umfang der Überlaufeinrichtung (5) gleichmäßig verteilt ausgebildet sind.

16. Vorrichtung nach einem der Ansprüche 4 bis 15, gekennzeichnet durch eine über dem Behälter (1) angeordnete, zu öffnende und zu schließende Haube.

17. Vorrichtung nach einem der Ansprüche 4 bis 16, gekennzeichnet durch eine Gaseinlaßvorrichtung.

18. Vorrichtung nach Anspruch 17, dadurch gekennzeichnet, daß die Überlauföffnungen (6) der Überlaufeinrichtung (5) auch eine Gasauslaßvorrichtung sind.

## Claims

1. Method for the wet treatment of substrates in a container, into which at least one liquid is introduced and discharged by way of an overflow equipment, characterised in that the overflow equipment floats on the liquid in the container and, on release or flooding of the substrate disposed in the container, lowers together with the liquid surface until below the substrate or rises from there.

2. Method according to claim 1, characterised in that the liquid flows out of the container by way of overflow openings of the overflow equipment as well as by way of at least one duct connected therewith.

3. Device for the wet treatment of substrates (3) in a container (1), which has at least one liquid inlet (11) and a liquid overflow equipment (5) with openings (6) for discharge of a liquid, characterised in that the overflow equipment (5) is provided so as to be capable of floating on the liquid surface (4) in the container (1) and, on release or flooding of the substrate (3) disposed in the container (1), can lower together with it until below the substrate (3) or can rise from there.

4. Device according to claim 3, characterised in that the overflow equipment (5) has liquid overflow openings (6).

5. Device according to claim 3 or 4, characterised in that the overflow equipment (5) has liquid discharge devices (7).

6. Device according to one of claims 3 to 5, characterised in that at least one liquid discharge duct (7) is provided between the overflow equipment (5) and at least one container opening (8).

7. Device according to claim 6, characterised in that the container opening (8) is provided at the base of the container (1).

8. Device according to claim 6 or 7, characterised in that the liquid discharge duct (7) is an elastic hose.

9. Device according to claim 6 or 7, characterised in that the liquid discharge duct (7) is a bellows-like hose.

10. Device according to claim 6 or 7, characterised in that the liquid discharge duct (7) is a telescopic pipe.

11. Device according to claim 6 or 7, characterised in that the liquid discharge duct (7) is a pipe which is sealingly pushable in and pushable out through the container opening (8).

12. Device according to one of claims 4 to 11, characterised in that the overflow equipment (5) is a ring which surrounds the substrate and is capable of floating.

13. Device according to one of claims 4 to 12, characterised in that the circumferential shape of the overflow equipment (5) corresponds to the cross-sectional shape of the container interior space.

14. Device according to one of claims 4 to 13, characterised in that the overflow equipment (5) is guided in the container during its lowering or raising.

15. Device according to one of claims 4 to 14, characterised in that the overflow openings (6) are formed to be uniformly distributed over the circumference of the overflow equipment (5).

16. Device according to one of claims 4 to 15, characterised by an openable and closable hood arranged over the container (1).

17. Device according to one of claims 4 to 16, characterised by a gas inlet device.

18. Device according to claim 17, characterised in that the overflow openings (6) of the overflow equipment (5) are also a gas outlet device.

## Revendications

1. Procédé de traitement par voie humide de substrats dans un récipient, dans lequel est introduit au moins un liquide et est évacué par une installation de débordement, caractérisé en ce que l'installation de débordement flotte sur le liquide dans le récipient et, lors de la libération respectivement de la mise en eau des substrats se trouvant dans le récipient. s'abaisse conjointement avec la surface du liquide jusque sous les substrats respectivement remonte à partir de là.

2. Procédé selon la revendication 1, caractérisé en ce que le liquide s'écoule par des ouvertures de débordement de l'installation de débordement ainsi que par au moins un conduit relié à celle-ci du récipient.

3. Dispositif pour le traitement par voie humide de substrats (3) dans un récipient (1) qui présente au moins une entrée de liquide (11) et une installation de débordement de liquide (5) avec des ouvertures (6) pour l'évacuation d'un liquide, caractérisé en ce que l'installation de débordement (5) est prévue d'une manière flottante sur la surface (4) du liquide dans le récipient (1) et, lors de la libération respectivement de la mise en eau des substrats (3) se trouvant dans le récipient (1) s'abaisse conjointement avec celle-ci jusque sous les substrats (3) respectivement peut être remontée à partir de là.

4. Dispositif selon la revendication 3, caractérisé en ce que l'installation de débordement (5) présente des ouvertures de débordement de liquide (6).

5. Dispositif selon la revendication 3 ou 4, caractérisé en ce que l'installation de débordement (5) présente des installations d'écoulement de liquide (7).

6. Dispositif selon l'une des revendications 3 à 5, caractérisé en ce qu'il est prévu au moins un conduit d'évacuation de liquide (7) entre l'installation de débordement (5) et au moins une ouverture de récipient (8).

7. Dispositif selon la revendication 6, caractérisé en ce que l'ouverture de récipient (8) est prévue au fond du récipient (1).

8. Dispositif selon la revendication 6 ou 7, caractérisé en ce que le conduit d'évacuation de liquide (7) est un tuyau élastique.

9. Dispositif selon la revendication 6 ou 7, caractérisé en ce que le conduit d'évacuation de liquide (7) est un tuyau semblable à un soufflet.

10. Dispositif selon la revendication 6 ou 7, caractérisé en ce que le conduit d'évacuation de liquide (7) est un tube télescopique.

11. Dispositif selon la revendication 6 ou 7, caractérisé en ce que le conduit d'évacuation de liquide (7) est un tube qui peut être introduit et sorti d'une manière étanche à travers l'ouverture (8) du récipient.

12. Dispositif selon l'une des revendications 4 à 11, caractérisé en ce que l'installation de débordement (5) est un anneau flottant, entourant les substrats.

13. Dispositif selon l'une des revendications 4 à 12, caractérisé en ce que la forme périphérique de l'installation de débordement (5) correspond à la forme en section transversale de l'espace intérieur du récipient.

14. Dispositif selon l'une des revendications 4 à 13, caractérisé en ce que l'installation de débordement (5) est guidée pendant son abaissement respectivement relèvement dans le récipient (1).

15. Dispositif selon l'une des revendications 4 à 14, caractérisé en ce que les ouvertures de débordement (6) sont réparties uniformément sur le pourtour de l'installation de débordement (5).

16. Dispositif selon l'une des revendications 4 à 15, caractérisé par un capot disposé au-dessus du récipient (1), pouvant être ouvert et fermé.

17. Dispositif selon l'une des revendications 4 à 16, caractérisé par un dispositif d'entrée de gaz.

18. Dispositif selon la revendication 17, caractérisé en ce que les ouvertures de débordement (6) de l'installation de débordement (5) constituent également un dispositif de sortie de gaz.
